# FASCICULE DE BREVET EUROPEEN

(11) **EP 1 608 069 B1**
(45) Date de publication et mention de la délivrance du brevet: **08.08.2007**
(21) Numéro de dépôt: 05105121.7
(22) Date de dépôt: 10.06.2005
(51) Int. Cl.: H03K 19/00, G06F 1/28

(54) **Procédé de commande d'un interrupteur analogique**
Verfahren zur Steuerung eines Analogschalters
Method for controling an analog switch

(30) Priorité: 11.06.2004 FR 0451266
(43) Date de publication de la demande: 21.12.2005
(73) Titulaire: COMMISSARIAT A L'ENERGIE ATOMIQUE, 75015 Paris (FR)
(72) Inventeur: Alacoque, Laurent, 38340 Voreppe (FR); Morche, Dominique, 38240 Meylan (FR); Belleville, Marc, 38120 Saint Egreve (FR)
(74) Mandataire: Poulin, Gérard

(56) Documents cités:
- EP-A- 0 899 714
- EP-A- 1 168 619
- WO-A-99/13592
- US-B1- 6 522 187
- WALTARI M ET AL: "A self-calibrated pipeline ADC with 200MHz if sampling frontend" ISSCC 2002 SESSION 18 CONVERTER TECHNIQUES, vol. 1, 2002, pages 314-469, XP010585583
- M. DESSOUKY AND A. KAISER: "Input Switch configuration suitable for rail-to-rail operation of switched opamp circuits" ELECTRONICS LETTERS, vol. 35, no. 1, 7 janvier 1999 (1999-01-07), pages 8-10, XP002311885
- HUI PAN ET AL: "A 3.3V 12b, 50MSample/s A/D Converter in 0.6/spl mu/m CMOS with over 80dB SFDR" ISSCC 2000 SESSION2 NYQUIST-RATE DATA CONVERTERS PAPER MP 2.4, 7 février 2000 (2000-02-07), pages 40-41, XP010378960

## Description

### DOMAINE TECHNIQUE ET ART ANTÉRIEUR

L'invention concerne le domaine de l'électronique analogique, et notamment un procédé de commande d'un interrupteur analogique pour la réduction de l'erreur de distorsion harmonique due à l'injection de charges.

Classiquement dans un circuit, un interrupteur MOS analogique est en série sur le chemin du signal et introduit nécessairement une erreur qui se traduit par une différence de tension entre ses deux terminaux.

Une partie de cette erreur est systématique et ne dépend donc pas du signal ; l'autre partie, en revanche, en étant dépendante du signal, se traduit par une déformation du signal qu'il est nécessaire de maintenir à un niveau aussi faible que possible.

Cette déformation du signal est quantifiée par sa distorsion harmonique.

Pour la diminuer, deux solutions peuvent être envisagées : réduire l'erreur en valeur absolue, ou linéariser l'erreur, c'est-à-dire en réduire la part qui dépend du signal, quitte à la rendre plus grande en valeur absolue.

Les interrupteurs analogiques réalisés en technologie MOS souffrent de diverses limitations :
- leur résistance à l'état passant n'est pas nulle et est fonction d'un certain nombre de paramètres technologiques et de conception ;
- les transitions de l'état passant à l'état bloqué induisent une fuite des charges du canal, connue sous le nom d'injection de charges.

Ces deux phénomènes contribuent à réduire les performances des circuits analogiques, spécialement dans le cas de circuits à capacités commutées où le signal est représenté sous la forme de charges.

Dans le cadre de convertisseurs à haute précision, ces deux types d'erreur deviennent un facteur limitant de la résolution et de la distorsion harmonique.

Le document de Bing J. Sheu et Chenming Hu, intitulé "Switch-induced error voltage on a switched capacitor", IEEE journal of Solid-State circuits, SC-19(4), 1984, donne une explication physique et une expression analytique aux erreurs de charges observées lors de l'injection de charges dans un transistor utilisé en interrupteur analogique.

Le phénomène d'injection de charges est vu comme la superposition de deux phénomènes :
- la charge du canal du transistor interrupteur s'évacue dans le drain et la source (le substrat n'intervient pratiquement pas étant donné sa constante de temps plus élevée). Cette erreur est proportionnelle à la charge stockée dans le canal et donc à sa surface (définie pas ses largeur et longueur, W et L) et à la tension de grille Vg.
- une partie de l'horloge appliquée sur la grille est injectée dans le drain du transistor interrupteur via les capacités de recouvrement grille/drain et via la capacité de jonction grille/canal tant que le canal est formé. Cette erreur, proportionnelle à W et à la rapidité de l'horloge est appelée « clock feedthrough ».

Au fur et à mesure de l'évolution des technologies, la réduction de l'épaisseur de l'oxyde de grille et de la tension d'alimentation et l'augmentation de la rapidité des fronts d'horloge ont rendu prépondérante cette erreur d'injection de charge.

Ceci a donné lieu à la création de nouveaux interrupteurs aux schémas beaucoup plus complexes, particulièrement pour les interrupteurs d'entrée sur lesquels la plus grande partie de la contrainte est reportée.

En effet, la conductance (et donc les dimensions) des interrupteurs d'entrée est basée à la fois sur la valeur maximale du signal d'entrée et sur sa fréquence, par opposition aux interrupteurs internes dont la conductance est basée sur la seule valeur maximale du signal.

Parmi les techniques envisagées, le « clock-doubling », ou technique de doublement de l'horloge, qui double la valeur de la tension d'horloge, permet d'atténuer l'erreur de fin de charge en augmentant la conductance des interrupteurs d'entrée.

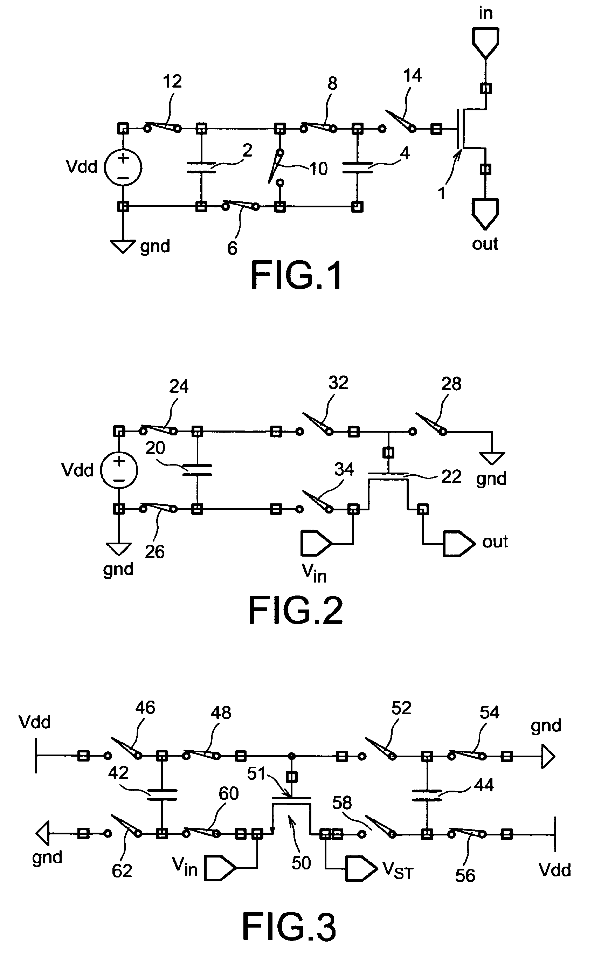

Le schéma de principe d'un interrupteur 1 commandé par un signal en « clock-doubling » est représenté sur la figure 1.

Un tel dispositif met en oeuvre des capacités 2, 4.

Au cours d'une première phase, ces deux capacités sont chargées à Vdd par fermeture des interrupteurs 6, 8, 12.

Au cours d'une deuxième phase, l'armature inférieure de l'une est connectée à l'armature supérieure de l'autre, par fermeture de l'interrupteur 10, formant ainsi une capacité série chargée à une tension 2Vdd.

On peut ainsi commander le transistor 1 via l'interrupteur 14, avec une tension 2Vdd.

Bien qu'efficace, cette technique est stressante pour le transistor 1. Elle engendre en effet des tensions Grille - Source de valeur 2Vdd et peut donc détériorer l'oxyde de grille du transistor 1.

On lui préfère donc la technique dite de « Clock Boosting », décrite par M. Dessouky et A. Kaiser dans « Input switch configuration for suitable rail-to-rail operation of switched opamps circuits », IEE Electronic Letters, 35(1), 1999, pour laquelle la tension grille-source est fixée à Vdd quelle que soit la tension du signal.

Le principe du « clock Boosting » est représenté sur la figure 2.

Une capacité 20 est chargée pendant une première phase (par fermeture des interrupteurs 24 et 26) et est appliquée aux bornes grille/source d'un transistor 22 pendant une deuxième phase (par fermeture des interrupteurs 32 et 34), durant laquelle elle agit comme une batterie. Pendant la première phase, le transistor 28 est fermé : la grille du transistor 22 est à la masse ou au potentiel GND.

Cette technique permet une amélioration sensible des performances d'un interrupteur d'entrée : la distorsion harmonique, entre autre, est réduite d'un facteur dix à cent par rapport aux solutions classiques à base d'interrupteurs de polarités complémentaires (CMOS).

Les performances de ces interrupteurs ne sont pourtant pas assez satisfaisantes en regard de la linéarité souhaitée, notamment pour des applications de télécommunication réalisées en capacités commutées.

Il se pose donc le problème de réaliser un procédé et un dispositif de commande d'un interrupteur analogique à distorsion harmonique réduite.

### EXPOSÉ DE L'INVENTION

L'invention proposée permet de réduire la distorsion harmonique introduite par un interrupteur analogique, utilisant notamment un transistor, par exemple de type MOS.

L'invention a pour objet un procédé de commande d'un interrupteur analogique comportant un transistor auquel est appliquée une tension d'entrée Vin, procédé dans lequel :
- on applique à la grille du transistor, pendant une première phase, une première tension, dépendante ou fonction de la tension d'entrée Vin et d'un premier potentiel V1, la première tension étant apte à rendre ledit transistor passant,
- on applique à la grille du transistor, pendant une deuxième phase, une deuxième tension, dépendante ou fonction de la tension d'entrée Vin et d'un deuxième potentiel V2, la deuxième tension étant apte à bloquer ledit transistor, la différence entre la première tension et la deuxième tension étant indépendante de la tension d'entrée Vin.

Selon une première variante du procédé pour laquelle le transistor est un transistor de type N, la première tension peut être égale à Vin + V1, tandis que la deuxième tension peut être égale à Vin + V2.

Selon une deuxième variante du procédé pour laquelle le transistor est un transistor de type P, la première tension peut être égale à Vin - V1, tandis que la deuxième tension peut être égale à Vin - V2.

Le premier potentiel et le deuxième potentiel peuvent être des potentiels fixes ou constants.

Le premier potentiel V1 peut être supérieur à la tension de seuil dudit transistor. Le premier potentiel V1 peut être également positif.

Le deuxième potentiel V2 peut être inférieur à la tension de seuil dudit transistor.

Selon une possibilité de mise en oeuvre, le premier potentiel V1 et le deuxième potentiel V2 peuvent être égaux en valeur absolue ou être tels que V1=-V2.

Selon une variante, le premier potentiel et le deuxième potentiel peuvent être égaux en valeur absolue à une tension Vdd ou être tels que V1=-V2=Vdd. Une telle variante peut permettre de maximiser la conductance du transistor à l'état passant et de minimiser les fuites du transistor à l'état bloqué. La tension Vdd peut être une tension supérieure à la tension de seuil du transistor. La tension Vdd peut être une tension de polarisation ou une tension maximale autorisée par la filière technologique du transistor.

L'invention a également pour objet un procédé de commande d'un interrupteur analogique comportant un transistor, auquel est appliquée une tension d'entrée Vin, procédé dans lequel on applique au transistor un signal d'horloge, ou un signal de grille ou de commande, symétrique par rapport à la tension d'entrée.

L'invention met également en oeuvre un procédé de commande d'un interrupteur analogique comportant un transistor, auquel est appliquée une tension d'entrée Vin, procédé dans lequel :
- on applique à la grille du transistor, pendant une première phase, une première tension, Vin + Vdd,
- on applique à la grille du transistor, pendant une deuxième phase, une deuxième tension, Vin - Vdd, symétrique de la première tension par rapport à la tension d'entrée Vin.

Selon l'invention, pour réduire la distorsion harmonique due à l'erreur d'injection de charge, on rend cette erreur la plus indépendante possible du signal.

La première tension Vin + Vdd peut être appliquée, pendant la première phase, par application d'un premier condensateur chargé à Vdd, entre la grille et une tension d'entrée Vin ou un noeud au potentiel Vin.

La deuxième tension Vin - Vdd peut être appliquée, pendant la deuxième phase, par application d'un deuxième condensateur chargé à - Vdd, entre la grille et la tension d'entrée Vin, ou un noeud au potentiel Vin, ou la tension de sortie V_{ST}.

Le deuxième condensateur peut se recharger pendant la première phase, le premier condensateur se rechargeant pendant la deuxième phase.

La première tension peut être appliquée par commutation d'au moins un interrupteur.

La deuxième tension peut être appliquée par commutation d'au moins un interrupteur.

Le premier condensateur peut être chargé à partir d'une source de tension Vdd dont il est isolé, en cours de décharge, par un transistor dont la grille est reliée à la grille du transistor de l'interrupteur analogique.

Ce transistor peut être à l'état bloqué lorsque la grille du transistor de l'interrupteur analogique est à l'état haut et étant à l'état passant lorsque la grille du transistor de l'interrupteur analogique est à l'état bas.

La deuxième tension est de préférence appliquée via un transistor à corps flottant ou à n (n>2) caissons.

Le deuxième condensateur peut être relié à la masse dont il est isolé, en cours de décharge, par un transistor dont la grille est reliée à la grille du transistor de l'interrupteur analogique.

Le transistor peut être à l'état bloqué lorsque la grille du transistor de l'interrupteur analogique est à l'état bas et étant à l'état passant lorsque la grille du transistor de l'interrupteur analogique est à l'état haut.

L'invention concerne également un dispositif de commande d'un interrupteur analogique comportant un transistor, ce dispositif de commande comportant :
- des moyens pour appliquer une tension d'entrée Vin audit transistor,
- des moyens pour appliquer à la grille du transistor, pendant une première phase, une première tension dépendante ou fonction de la tension d'entrée Vin et d'un premier potentiel V1, la première tension étant apte à rendre passant ledit transistor,
- des moyens pour appliquer à la grille du transistor, pendant une deuxième phase, une deuxième tension, dépendante ou fonction de la tension d'entrée Vin et d'un deuxième potentiel V2, la deuxième tension étant apte à rendre bloqué ledit transistor, la différence entre la première tension et la deuxième tension étant indépendante de vin.

Selon une première variante pour laquelle le transistor est un transistor de type N, la première tension peut être égale à Vin + V1, tandis que la deuxième tension peut être égale à Vin + V2.

Selon une seconde variante pour laquelle le transistor est un transistor de type P, la première tension peut être égale à Vin - V1, tandis que la deuxième tension peut être égale à Vin - V2.

Le premier potentiel V1 et le deuxième potentiel V2 peuvent être des potentiels fixes ou constants.

Le premier potentiel V1 peut être positif et supérieur à la tension de seuil dudit transistor.

Le deuxième potentiel V2 peut être inférieur à la tension de seuil dudit transistor.

Selon une possibilité de mise en oeuvre, le premier potentiel V1 et le deuxième potentiel V2 peuvent être tels que V1=-V2.

Selon une variante, le premier potentiel V1 et le deuxième potentiel V2 peuvent être tels que V1=-V2=Vdd.

La tension Vdd peut être supérieure à la tension de seuil du transistor. La tension Vdd peut être une tension de polarisation ou une tension maximale autorisée par la filière technologique du transistor.

L'invention concerne également un dispositif de commande d'un interrupteur analogique comportant un transistor, ce dispositif de commande comportant :
- des moyens pour appliquer une tension d'entrée Vin,
- des moyens pour appliquer à la grille du transistor, pendant une première phase, une première tension, Vin + Vdd,
- des moyens pour appliquer à la grille du transistor, pendant une deuxième phase, une deuxième tension, Vin - Vdd, symétrique de la première par rapport à la tension d'entrée Vin.

Un premier condensateur peut permettre d'appliquer la première tension Vin + Vdd, pendant la première phase, entre la grille et la tension d'entrée Vin.

Un deuxième condensateur peut permettre d'appliquer la deuxième tension Vin - Vdd, pendant la deuxième phase, entre la grille et la tension d'entrée Vin, ou la tension de sortie V_{ST}.

Des moyens peuvent permettre de recharger le deuxième condensateur pendant la première phase et d'autres moyens peuvent permettre de recharger le premier condensateur pendant la deuxième phase.

Avantageusement, le dispositif comporte au moins un interrupteur pour appliquer la première tension.

Il peut en outre comporter au moins un interrupteur pour appliquer la deuxième tension.

Selon un mode de réalisation, il comporte une source de tensions Vdd pour charger le premier condensateur et des moyens pour isoler, en cours de décharge, la source de tension du premier condensateur.

Des moyens peuvent être prévus pour isoler, en cours de décharge, la source de tension du premier condensateur.

Ces moyens comportent par exemple un transistor dont la grille est reliée à la grille du transistor de l'interrupteur analogique.

Ledit transistor peut être à l'état bloqué lorsque la grille du transistor de l'interrupteur analogique est à l'état haut et à l'état passant lorsque la grille du transistor de l'interrupteur analogique est à l'état bas.

Avantageusement, un transistor à corps flottant ou à n (n>2) caissons permet d'appliquer la deuxième tension.

Le deuxième condensateur peut être relié à la masse dont il est isolé, en cours de décharge, par un transistor dont la grille est reliée à la grille du transistor de l'interrupteur analogique.

Ledit transistor peut être à l'état bloqué lorsque la grille du transistor de l'interrupteur analogique est à l'état bas et à l'état passant lorsque la grille du transistor de l'interrupteur analogique est à l'état haut.

### BRÈVE DESCRIPTION DES DESSINS

- Les figures 1 et 2 représentent des dispositifs selon l'art antérieur,
- la figure 3 représente un schéma d'un dispositif selon l'invention,
- la figure 4 illustre une comparaison entre un procédé connu et un procédé selon l'invention,
- la figure 5 représente une réalisation d'un dispositif selon l'invention,
- les figures 6 - 8 montrent des tranches de silicium en technologie standard, SOI et triple caisson,
- les figures 9A - 9C résument différents principes d'horloges,
- la figure 10 montre les résultats d'une simulation pour un procédé selon l'invention.

### EXPOSÉ DÉTAILLÉ DE MODES DE RÉALISATION PARTICULIERS

Un exemple de circuit selon l'invention est illustré en figure 3.

Ce circuit permet d'améliorer la linéarité des interrupteurs, malgré l'erreur d'injection de charge, grâce à un nouveau principe d'horloge, plus symétrique par rapport au signal.

Selon l'invention, on applique sur la grille d'un transistor 50, en particulier de type MOS : pendant une première phase, une première tension, dépendante ou fonction d'une tension d'entrée Vin et d'un premier potentiel V1, la première tension étant apte à rendre ledit transistor passant. Puis, on applique à la grille du transistor, pendant une deuxième phase, une deuxième tension, dépendante ou fonction de la tension d'entrée Vin et d'un deuxième potentiel V2, la deuxième tension étant apte à bloquer ledit transistor, la différence entre la première tension et la deuxième tension étant indépendante de la tension d'entrée Vin. L'injection de charge au niveau du transistor peut être ainsi rendue d'avantage indépendante du signal d'entrée.

Le transistor 50 peut être par exemple un transistor de type N. La première tension peut être égale à vin + V1, tandis que la deuxième tension peut être égale à vin + V2.

Le premier potentiel V1 et le deuxième potentiel V2 peuvent être des potentiels fixes ou constants. Le premier potentiel V1 peut être supérieur à la tension de seuil dudit transistor. Le premier potentiel V1 peut être également positif. Le deuxième potentiel V2 peut être inférieur à la tension de seuil dudit transistor. Selon une possibilité de mise en oeuvre, le premier potentiel V1 et le deuxième potentiel V2 peuvent être égaux en valeur absolue ou être tels que V1=-V2. Selon une variante, le premier potentiel et le deuxième potentiels peuvent être égaux en valeur absolue à une tension Vdd ou être tels que V1=-V2=Vdd, avec Vdd une tension de polarisation, supérieure à la tension de seuil du transistor.

Selon cette variante, on applique sur la grille d'un transistor 50, par exemple de type NMOS, des tensions symétriques, par rapport à une tension Vin d'entrée d'un transistor interrupteur, pendant une première phase puis pendant une deuxième phase.

La tension Vin d'entrée provient par exemple d'un microphone, d'une ligne téléphonique de type ADSL ou encore d'une chaîne de réception radiofréquence.

Une tension égale à Vin + Vdd est appliquée durant une première phase, ou état « on », et une tension égale à Vin - Vdd est appliquée durant une deuxième phase, ou état « off ».

Ceci permet de rendre l'erreur d'injection de charge quasiment indépendante de la valeur du signal, réduisant ainsi la distorsion harmonique.

Pendant la première phase, un condensateur 42 initialement chargé à Vdd, (par fermeture des interrupteurs 46 et 62) est appliqué entre la grille 51 du transistor 50 et Vin (par fermeture des interrupteurs 48 et 60).

Une tension égale à Vdd + Vin est alors appliquée à cette grille 51.

Pendant la même phase, un deuxième condensateur 44 se recharge à la tension -Vdd (par fermeture des interrupteurs 54 et 56).

Pendant une deuxième phase, le premier condensateur se recharge (les interrupteurs 48 et 60 sont ouverts et les interrupteurs 46 et 62 fermés) tandis que le condensateur 44 est appliqué entre la grille et le drain du transistor 50, mais avec une tension de signe opposé au premier. En variante, le condensateur pourrait être appliqué entre la grille et la source du transistor 50. En effet, en fin de charge, source et drain sont au même potentiel (Vin=V_{ST}).

Ceci a pour effet d'appliquer une tension Vin-Vdd sur la grille du transistor 51.

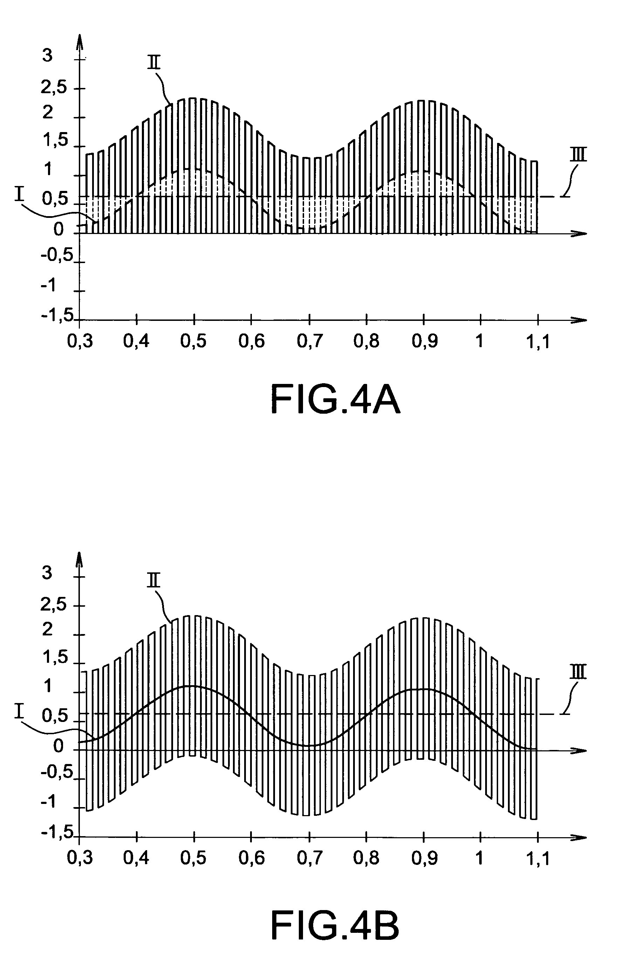

Les figures 4A et 4B montrent plusieurs cycles de charge et de décharge d'une capacité par un interrupteur analogique par un signal sinusoïdal, le graphique du bas (figure 4B) correspondant à un cas symétrique, selon l'invention, celui du haut (figure 4A) au cas de « clock-boosting » connu.

Sur chaque graphe sont représentés les signaux d'entrée (courbe I), de sortie (entre la courbe I et la ligne horizontale III) et de commande (ou de grille : courbe II).

On voit, sur le graphique du bas, que le signal de grille tout à fait symétrique par rapport au signal d'entrée I et au signal de sortie, qui peuvent avoir une fréquence pouvant aller jusqu'à quelques centaines de MégaHertz.

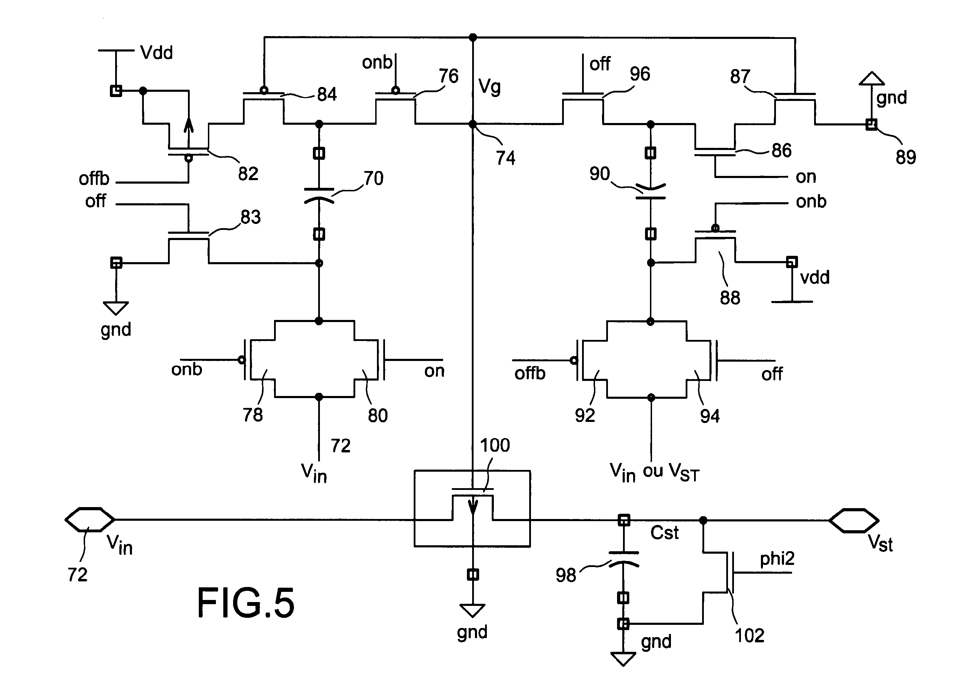

La figure 5 illustre une réalisation détaillée d'un circuit selon l'invention.

Ce circuit permet de générer des horloges pouvant atteindre +2Vdd et -Vdd à partir d'une alimentation de Vdd.

L'explication du fonctionnement de ce circuit est la suivante.

Pendant une première phase, ou phase « on », une capacité 70, initialement chargée à Vdd, est appliqué entre l'entrée 72 et la grille 74 via des transistors 76, et 78, 80 qui forment un interrupteur en structures MOS à polarités complémentaires.

L'armature négative de la capacité 70 est connectée à l'entrée 72 (à la tension Vin) et son armature positive à la grille 74. Le signal grille monte donc à une tension V = Vin + Vdd.

A ce moment, le transistor 82 qui, avec le transistor 83, permet de charger la capacité 70 à Vdd, pourrait se mettre à conduire puisque sa source monte à une tension supérieure à sa grille.

Le résultat serait que le signal de grille se déchargerait dans la source de tension Vdd.

Pour empêcher ceci, un transistor 84 est mis en série sur ce noeud.

Ce transistor, dont la grille est connectée à la grille 74, permet d'isoler la source de tension à Vdd de la grille 74, quand cette dernière est à l'état haut. Il est passant quand la grille 74 est à l'état bas.

Toujours pendant la première phase, les transistors 86 et 88 chargent la capacité 90 à une tension Vdd.

Tous les autres transistors sont à l'état haute impédance.

A la fin de cette première phase, les transistors 76, et 78, 80 sont coupés et isolent ainsi la capacité de la grille 74.

Au début de la deuxième phase, ou état « off », les transistors 92, 94 deviennent passant et connectent l'armature positive de la capacité 90 au signal Vin.

Il est aussi possible de connecter cette armature au signal Vst puisque, en fin de charge (fin de l'état « on ») les tensions Vin et Vst sont les mêmes.

Lorsque la tension de grille (74) plonge sous le niveau 0, le transistor 86 peut se retrouver avec une tension grille-source positive, se mettre à conduire et ainsi décharger la capacité 90 dans la masse.

Pour empêcher ceci, on a recours à un transistor 87 en série sur le chemin masse 89-grille 74 et dont la grille est reliée à la grille 74. Ce transistor est bloqué et isole la masse 89 de la grille 74 lorsque cette dernière est à l'état bas et est transparent lorsqu'elle est à l'état haut.

Toujours pendant l'état « off », les transistors 82 et 83 sont passants pour recharger les pertes de charges de la capacité 70. A la fin de la phase « off », les transistors 96 et 92,94 sont coupés, isolant ainsi la capacité 90 de la grille 74.

L'armature négative de la capacité 90 est connectée à la grille 74 par le transistor 96. Le signal de grille 74 descend donc à la tension V' = Vin - Vdd (ou Vst - Vdd).

Cette tension peut être voisine de -Vdd dans le cas où Vin est proche de 0 ; dans ce cas, la diode source/substrat du transistor 96 peut se retrouver en direct ce qui empêche le noeud 74 de descendre en dessous de -V_{diode}.

Les technologies SOI permettent de résoudre ce problème en raison de l'isolation complète du corps et rendent donc possible cette génération de tensions de commandes négatives. On utilise en particulier un transistor 96 à corps flottant.

D'autres technologies telles que les technologies à triple caisson peuvent également être utilisées.

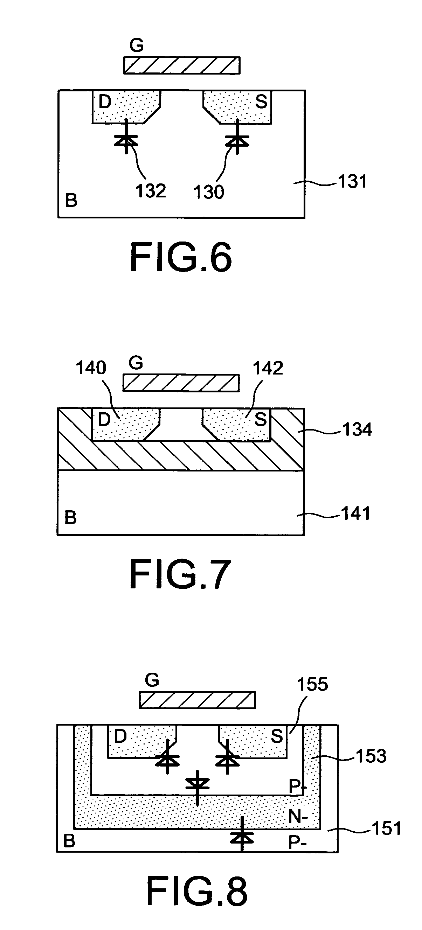

Les figures 7 et 8 illustrent le principe d'isolation source/substrat, respectivement pour les technologies SOI et triple caisson.

Sur les figures 6 - 8, trois transistors MOS de type N sont représentés en coupe pour les technologies standard (figure 6), SOI (figure 7) et triple caisson (figure 8).

Dans la technologie standard (figure 6) deux diodes substrat/drain 130 et substrat/source 132 apparaissent.

Le substrat 131 étant connecté à la masse, toute tension inférieure à la masse moins un seuil de diode rend l'une de ces diodes passante.

Ce problème est résolu en technologie SOI (figure 7) où un isolant 134 sépare le substrat 141 du drain 140 et de la source 142.

Les technologies à triple caissons (figure 8) compensent également le problème par un caisson externe 153 dopé N- (dans un substrat 151 P-).

Ce caisson externe contient un autre caisson dopé 155 P- permettant la constitution d'un transistor MOS de type N.

Cette construction permet d'obtenir une diode inverse caisson/substrat qui empêche l'épanchement d'une tension négative dans la masse du substrat.

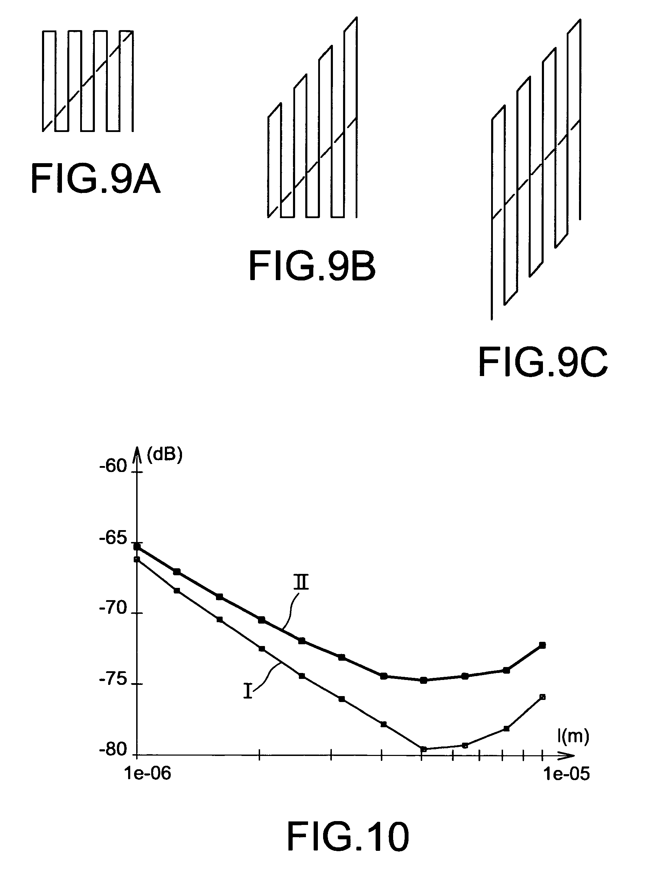

Les figures 9A - 9C résument les différents principes de tension de grille du transistor interrupteur : de gauche à droite sont représentées le principe d'une tension de grille standard (figure 9A), le principe d'une tension de grille avec un « clock-boosting » (figure 9B) et enfin le principe d'une tension de grille avec « clock-boosting » symétrique (figure 9C). La tension Vin est représentée en pointillées. Le signal ou la tension de grille ou de commande constitue le signal d'horloge.

La figure 10 montre des résultats d'une simulation respectivement pour un procédé selon l'invention, en « clock-boosting » symétrique (courbe I) et celle de « clock-boosting » non symétrique (courbe II).

La distorsion harmonique d'un transistor N monté en interrupteur d'entrée y est tracée en fonction de sa largeur W.

Les résultats montrent un gain de la technique symétrique par rapport à la non symétrique, quelle que soit la largeur du transistor.

Le minimum de distorsion est lui aussi amélioré, d'environ 10dB.

L'invention permet l'amélioration de la linéarité des interrupteurs analogiques et permet donc l'amélioration des performances de ces composants utilisés dans de nombreux domaines dont, en particulier, les applications de télécommunication, les convertisseurs analogiques numériques et les circuits à capacités commutées.

Elle représente une nouvelle solution à l'erreur d'injection de charges qui va devenir de plus en plus prépondérante avec la diminution de l'oxyde de grille et des tensions d'alimentation.

Elle s'applique particulièrement bien aux technologies isolées de type SOI qui permettent de réaliser des transistors à corps flottant, comme expliqué ci-dessus, en particulier pour le transistor 96.

L'invention n'est pas limitée à une commande de transistors de type N et peut s'appliquer à des transistors de type P, en particulier à des transistors de type PMOS. Dans ce cas, on peut appliquer sur la grille d'un transistor PMOS, pendant une première phase, une première tension Vin - V1, la première tension étant apte à rendre ledit transistor passant, puis, pendant une deuxième phase, une deuxième tension Vin - V2, la deuxième tension étant apte à bloquer ledit transistor, la différence entre la première tension et la deuxième tension étant indépendante de la tension d'entrée Vin.

## Revendications

1. Procédé de commande d'un interrupteur analogique comportant un transistor (50, 100), auquel est appliqué une tension d'entrée Vin, procédé dans lequel :
- on applique à la grille du transistor, pendant une première phase, une première tension, fonction de la tension d'entrée Vin et d'un premier potentiel V1, la première tension étant apte à rendre ledit transistor passant,
- on applique à la grille du transistor, pendant une deuxième phase, une deuxième tension, fonction de Vin et d'un deuxième potentiel V2, la deuxième tension étant apte à bloquer ledit transistor, la différence entre la première tension et la deuxième tension étant indépendante de la tension d'entrée vin.

2. Procédé de commande d'un interrupteur analogique selon la revendication 1, le premier potentiel V1 et le deuxième potentiel V2 étant tels que V1=-V2.

3. Procédé de commande d'un interrupteur analogique selon la revendication 1 ou 2, le premier potentiel V1 et le deuxième potentiel V2 étant tels que V1=-V2=Vdd, avec Vdd un potentiel de polarisation.

4. Procédé de commande d'un interrupteur analogique selon la revendication 1 à 3, dans lequel le transistor est un transistor de type P, la première tension et la deuxième tension étant respectivement égales à Vin-V1 et à Vin-V2, avec V1 positif et supérieur à la tension de seuil dudit transistor, et V2 inférieur à la tension de seuil dudit transistor.

5. Procédé de commande d'un interrupteur analogique selon la revendication 1 à 3, dans lequel le transistor est un transistor de type N, la première tension et la deuxième tension étant respectivement égales à vin+V1 et vin+V2, avec V1 positif et supérieur à la tension de seuil dudit transistor et V2 inférieur à la tension de seuil dudit transistor.

6. Procédé de commande d'un interrupteur analogique selon l'une des revendications 1 à 3 dans lequel Vl=-V2=Vdd, et dans lequel :
- on applique à la grille du transistor, pendant la première phase, la première tension, Vin + Vdd,
- on applique à la grille du transistor, pendant une deuxième phase, la deuxième tension, Vin - Vdd, symétrique de la première par rapport à la tension d'entrée Vin.

7. Procédé selon la revendication 6, la première tension Vin + Vdd étant appliquée, pendant la première phase, par application d'un premier condensateur (42,70) chargé à Vdd, entre la grille et un noeud au potentiel Vin.

8. Procédé selon la revendication 7, la deuxième tension Vin - Vdd étant appliquée, pendant la deuxième phase, par application d'un deuxième condensateur (44,90) chargé à - Vdd, entre la grille et un noeud au potentiel Vin ou entre la grille et la tension de sortie V_{ST}.

9. Procédé selon la revendication 8, le deuxième condensateur se rechargeant pendant la première phase et le premier condensateur se rechargeant pendant la deuxième phase.

10. Procédé selon l'une des revendications 7 à 9, le premier condensateur (70) étant chargé à partir d'une source de tension Vdd dont il est isolé, en cours de décharge, par un transistor (84) dont la grille est reliée à la grille du transistor (100) de l'interrupteur analogique.

11. Procédé selon la revendication 10, le transistor (84) étant à l'état bloqué lorsque la grille du transistor (100) de l'interrupteur analogique est à l'état haut et étant à l'état passant lorsque la grille du transistor (100) de l'interrupteur analogique est à l'état bas.

12. Procédé selon l'une des revendications 6 à 11, dans lequel la deuxième tension est appliquée via un transistor (96) à corps flottant ou à n (n>2) caissons.

13. Procédé selon l'une des revendications 8 à 12, le deuxième condensateur (90) étant relié à la masse dont il est isolé, en cours de décharge, par un transistor (87) dont la grille est reliée à la grille du transistor (100) de l'interrupteur analogique.

14. Procédé selon la revendication 13, le transistor (87) étant à l'état bloqué lorsque la grille du transistor (100) de l'interrupteur analogique est à l'état bas et étant à l'état passant lorsque la grille du transistor (100) de l'interrupteur analogique est à l'état haut.

15. Procédé selon l'une des revendications 6 à 14, la première tension étant appliquée par commutation d'au moins un interrupteur (48, 60).

16. Procédé selon l'une des revendications 6 à 15, la deuxième tension étant appliquée par commutation d'au moins un interrupteur (52, 58).

17. Dispositif de commande d'un interrupteur analogique comportant un transistor (50,100), dispositif comportant:
- des moyens pour appliquer à la grille du transistor, pendant une première phase, une première tension, fonction d'une tension d'entrée Vin du transistor (50, 100) et d'un premier potentiel V1, la première tension étant apte à rendre le transistor passant,
- des moyens pour appliquer à la grille du transistor, pendant une deuxième phase, une deuxième tension fonction de la tension d'entrée Vin du transistor (50, 100) et d'un deuxième potentiel V2, la deuxième tension étant apte à rendre le transistor bloqué, la différence entre la première tension et la deuxième tension étant indépendante de vin.

18. Dispositif de commande selon la revendication 17, le premier potentiel V1 et le deuxième potentiel V2 étant tels que V1=-V2.

19. Dispositif de commande selon la revendication 17 ou 18, le premier potentiel V1 et le deuxième potentiel V2 étant tels que V1=-V2=Vdd avec Vdd un potentiel de polarisation.

20. Dispositif de commande selon l'une des revendications 17 à 19, dans lequel le transistor est un transistor de type P, la première tension et la deuxième tension étant respectivement égales à vin-V1 et à vin-V2, avec V1 positif et supérieur à la tension de seuil dudit transistor, et V2 inférieur à la tension de seuil dudit transistor.

21. Dispositif de commande selon l'une des revendications 17 à 19, dans lequel le transistor est un transistor de type N, la première tension et la deuxième tension étant respectivement égales à vin+V1 et vin+V2, avec V1 positif et supérieur à la tension de seuil dudit transistor et V2 inférieur à la tension de seuil dudit transistor.

22. Dispositif de commande d'un interrupteur analogique selon l'une des revendications 17 à 19, la première tension étant égale à Vin + Vdd, la deuxième tension étant symétrique de la première tension par rapport à la tension d'entrée Vin et égale à Vin - Vdd.

23. Dispositif selon la revendication 22, comportant un premier condensateur (42,70) pour appliquer la première tension Vin + Vdd, pendant la première phase, entre la grille et une tension d'entrée Vin.

24. Dispositif selon la revendication 23, comportant un deuxième condensateur (44,90) pour appliquer la deuxième tension Vin - Vdd, pendant la deuxième phase, entre la grille et une tension d'entrée Vin.

25. Dispositif selon la revendication 24, comportant des moyens (Vdd) pour recharger le deuxième condensateur pendant la première phase et des moyens pour recharger le premier condensateur pendant la deuxième phase.

26. Dispositif selon l'une des revendications 23 à 25, comportant une source de tension Vdd pour charger le premier condensateur (70) et des moyens (84) pour isoler, en cours de décharge, la source de tension du premier condensateur (70).

27. Dispositif selon la revendication 26 les moyens (84) pour isoler, en cours de décharge, la source de tension du premier condensateur (70) comportant un transistor (84) dont la grille est reliée à la grille du transistor (100) de l'interrupteur analogique.

28. Dispositif selon la revendication 27, ledit transistor (84) étant à l'état bloqué lorsque la grille du transistor (100) de l'interrupteur analogique est à l'état haut et étant à l'état passant lorsque la grille du transistor (100) de l'interrupteur analogique est à l'état bas.

29. Dispositif selon l'une des revendications 22 à 27, comportant en outre un transistor (96) à corps flottant ou à n (n>2) caissons pour appliquer la deuxième tension.

30. Dispositif selon l'une des revendications 24 à 29, le deuxième condensateur (90) étant relié à la masse dont il est isolé, en cours de décharge, par un transistor (87) dont la grille est reliée à la grille du transistor (100) de l'interrupteur analogique.

31. Dispositif selon la revendication 30, ledit transistor (87) étant à l'état bloqué lorsque la grille du transistor (100) de l'interrupteur analogique est à l'état bas et étant à l'état passant lorsque la grille du transistor (100) de l'interrupteur analogique est à l'état haut.

32. Dispositif selon l'une des revendications 22 à 31, comportant au moins un interrupteur (48, 60) pour appliquer la première tension.

33. Dispositif selon l'une des revendications 22 à 32, comportant au moins un interrupteur (52, 58) pour appliquer la deuxième tension.

## Claims

1. Method for controlling an analogue switch comprising a transistor (50, 100) to which an input voltage Vin is applied, wherein:
- during a first phase, a first voltage is applied to the transistor gate, the first voltage being a function of Vin and of a first potential V1 and being able to make said transistor conduct,
- during a second phase, a second voltage is applied to the transistor gate, the second voltage being a function of Vin and a second potential V2 and being able to block said transistor, the difference between the first and second voltages being independent of the input voltage Vin.

2. Method for controlling an analogue switch according to claim 1, the first potential V1 and the second potential V2 being such that V1=-V2.

3. Method for controlling an analogue switch according to claim 1 or 2, the first potential V1 and the second potential V2 being such that V1=-V2=Vdd, with Vdd being a bias potential.

4. Method for controlling an analogue switch according to claims 1 to 3, wherein the transistor is a P-type transistor, the first voltage and second voltage being respectively equal to Vin-V1 and Vin-V2, with V1 positive and exceeding the threshold voltage of said transistor, and V2 below the threshold voltage of said transistor.

5. Method for controlling an analogue switch according to claims 1 to 3, wherein the transistor is a N-type transistor, the first voltage and the second voltage being respectively equal to Vin+V1 and Vin+V2, with V1 positive and exceeding the threshold voltage of said transistor and V2 lower than the threshold voltage of said transistor.

6. Method for controlling an analogue switch according to one of the claims 1 to 3 in which V1=-V2=Vdd and wherein:
- the first voltage Vin+Vdd is applied to the transistor gate during the first phase,
- the second voltage Vin-Vdd, symmetrical to the first voltage with respect to the input voltage Vin, is applied to the transistor gate during a second phase.

7. Method according to claim 6, the first voltage Vin+Vdd being applied, during the first phase, by the application of a first capacitor (42, 70) charged to Vdd, between the gate and a node at potential Vin.

8. Method according to claim 7, the second voltage Vin-Vdd being applied, during the second phase, by the application of a second capacitor (44, 90) charged to -Vdd, between the gate and a node at potential Vin or between the gate and the output voltage V_{ST}.

9. Method according to claim 8, the second capacitor being recharged during the first phase and the first capacitor being recharged during the second phase.

10. Method according to one of the claims 7 to 9, the first capacitor (70) being charged from a voltage source Vdd from which it is isolated during discharge, by a transistor (84), whose gate is connected to the gate of the analogue switch transistor (100).

11. Method according to claim 10, the transistor (84) being in the blocked state when the gate of the analogue switch transistor is in the high state and in the conducting state when the gate of the analogue switch transistor (100) is in the low state.

12. Method according to one of the claims 6 to 11, wherein the second voltage is applied via a transistor (96) having a floating body or with n (n > 2) wells.

13. Method according to one of the claims 8 to 12, the second capacitor (90) being connected to earth from which it is isolated during discharge, by a transistor (87), whose gate is connected to the gate of the analogue switch transistor (100).

14. Method according to claim 13, the transistor (87) being in the blocked state when the gate of the analogue switch transistor (100) is in the low state and in the conducting state when the gate of the analogue switch transistor (100) is in the high state.

15. Method according to one of the claims 6 to 14, the first voltage being applied by switching at least one switch (48, 60).

16. Method according to one of the claims 6 to 15, the second voltage being applied by switching at least one switch (52, 58).

17. Device for controlling an analogue switch comprising a transistor (50, 100), said device comprising:
- means for applying to the gate of the transistor, during a first phase, a first voltage which is a function of the input voltage Vin of transistor (50, 100) and a first potential V1, the first voltage being able to make the transistor conducting,
- means for applying to the gate of the transistor, during a second phase, a second voltage which is a function of the input voltage Vin of transistor (50, 100) and a second potential V2, the second voltage being able to block the transistor, the difference between the first voltage and the second voltage exceeding Vin.

18. Controlling device according to claim 17, the first potential V1 and second potential V2 being such that V1=-V2.

19. Controlling device according to claim 17 or 18, the first potential V1 and second potential V2 being such that V1=-V2=Vdd, with Vdd a bias potential.

20. Controlling device according to one of the claims 17 to 19, wherein the transistor is a P-type transistor, the first voltage and second voltage being respectively equal to Vin-V1 and Vin-V2, with V1 positive and exceeding the threshold voltage of said transistor and V2 below the threshold voltage of said transistor.

21. Controlling device according to one of the claims 17 to 19, wherein the transistor is a N-type transistor, the first voltage and second voltage being respectively equal to Vin+V1 and Vin+V2, with V1 positive and exceeding the threshold voltage of said transistor and V2 below the threshold voltage of said transistor.

22. Device for controlling an analogue switch according to one of the claims 17 to 19, the first voltage being equal to Vin+Vdd, the second voltage being symmetrical to the first voltage with respect to the input voltage Vin and equal to Vin-Vdd.

23. Device according to claim 22, comprising a first capacitor (42, 70) for applying the first voltage Vin+Vdd during the first phase, between the gate and an input voltage Vin.

24. Device according to claim 23, comprising a second capacitor (44, 90) for applying the second voltage Vin-Vdd during the second phase, between the gate and an input voltage Vin.

25. Device according to claim 24, comprising means Vdd for recharging the second capacitor during the first phase and means for recharging the first capacitor during the second phase.

26. Device according to one of the claims 23 to 25, comprising a voltage source Vdd for charging the first capacitor (70) and means (84) for isolating during discharge the voltage source from the first capacitor (70).

27. Device according to claim 26, the means for isolating during discharge the voltage source from the first capacitor (70) comprising a transistor (84), whose gate is connected to the gate of the analogue switch transistor (100).

28. Device according to claim 27, said transistor (84) being in the blocked state when the gate of the analogue switch transistor (100) is in the high state and in the conducting state when the gate of the analogue switch transistor (100) is in the low state.

29. Device according to one of the claims 22 to 27, also comprising a transistor (96) having a floating body or with n (n > 2) wells for applying the second voltage.

30. Device according to one of the claims 24 to 29, the second capacitor (90) being connected to earth from which it is isolated during discharge by a transistor (87), whose gate is connected to the gate of the analogue switch transistor (100).

31. Device according to claim 30, said transistor (87) being in the blocked state when the gate of the analogue switch transistor (100) is in the low state and in the conducting state when the gate of the analogue switch transistor (100) is in the high state.

32. Device according to one of the claims 22 to 31, comprising at least one switch (48, 60) for applying the first voltage.

33. Device according to one of the claims 22 to 32, comprising at least one switch (52, 58) for applying the second voltage.

## Patentansprüche

1. Verfahren zur Steuerung eines Analogschalters mit einem Transistor (50, 100), an den eine Eingangsspannung Vin angelegt wird, wobei das Verfahren darin besteht:
- an das Gate des Transistors während einer ersten Phase eine erste Spannung anzulegen, abhängig von der Eingangsspannung Vin und einem ersten Potential V1, wobei die erste Spannung fähig ist, den genannten Transistor leitend zu machen,
- an das Gate des Transistors während einer zweiten Phase eine zweite Spannung anzulegen, abhängig von Vin und einem zweiten Potential V2, wobei die zweite Spannung fähig ist, den genannten Transistor zu sperren, wobei die Differenz zwischen der ersten Spannung und der zweiten Spannung von der Eingangsspannung Vin unabhängig ist.

2. Verfahren zur Steuerung eines Analogschalters nach Anspruch 1, wobei das erste Potential V1 und das zweite Potential V2 so sind, dass V1=-V2 ist.

3. Verfahren zur Steuerung eines Analogschalters nach Anspruch 1 oder 2, wobei das erste Potential V1 und das zweite Potential V2 so sind, dass V1=-V2=Vdd ist, mit Vdd als einem Polarisationspotential.

4. Verfahren zur Steuerung eines Analogschalters nach Anspruch 1 bis 3, in dem der Transistor ein Transistor des P-Typs ist, wobei die erste Spannung und die zweite Spannung jeweils gleich Vin-V1 und Vin-V2 sind, mit V1 positiv und höher als die Schwellenspannung des genannten Transistors, und V2 niedriger als die Schwellenspannung des genannten Transistors.

5. Verfahren zur Steuerung eines Analogschalters nach Anspruch 1 bis 3, in dem der Transistor ein Transistor des N-Typs ist, wobei die erste Spannung und die zweite Spannung jeweils gleich Vin+V1 und Vin+V2 sind, mit V1 positiv und höher als die Schwellenspannung des genannten Transistors, und V2 niedriger als die Schwellenspannung des genannten Transistors.

6. Verfahren zur Steuerung eines Analogschalters nach einem der Ansprüche 1 bis 3, in dem V1=-V2=Vdd ist und in dem:
- man an das Gate des Transistors während der ersten Phase die erste Spannung Vin + Vdd anlegt,
- man an das Gate des Transistors während einer zweiten Phase die zu der ersten Spannung in Bezug auf die Eingangsspannung Vin symmetrische zweite Spannung Vin
- Vdd anlegt.

7. Verfahren nach Anspruch 6, wobei die erste Spannung Vin + Vdd während der ersten Phase mit Hilfe eines zwischen dem Gate und einem Vin-Verbindungsknoten geschalteten, mit Vdd geladenen ersten Kondensators (42, 70) angelegt wird.

8. Verfahren nach Anspruch 7, wobei die zweite Spannung Vin - Vdd während der zweiten Phase mit Hilfe eines zwischen dem Gate und einem Vin-Verbindungsknoten oder zwischen dem Gate und der Ausgangsspannung V_{ST} geschalteten, mit -Vdd geladenen ersten Kondensators (44, 90) angelegt wird.

9. Verfahren nach Anspruch 8, wobei der zweite Kondensator sich während der ersten Phase wiederauflädt und der erste Kondensator sich während der zweiten Phase wiederauflädt.

10. Verfahren nach einem der Ansprüche 7 bis 9, wobei der erste Kondensator (70) durch eine Vdd-Spannungsquelle aufgeladen wird, von der er im Laufe der Entladung durch einen Transistor (84) getrennt wird, dessen Gate verbunden ist mit dem Gate des Transistors (100) des Analogschalters.

11. Verfahren nach Anspruch 10, wobei der Transistor (84) im gesperrten Zustand ist, wenn das Gate des Transistors (100) des Analogschalters im hohen Zustand ist, und im leitenden Zustand ist, wenn das Gate des Transistors (100) des Analogschalters im niedrigen Zustand ist.

12. Verfahren nach einem der Ansprüche 6 bis 11, in dem die zweite Spannung über einen Transistor (96) des Floating-Body-Typs oder mit n (n>2) Wannen angelegt wird.

13. Verfahren nach einem der Ansprüche 6 bis 12, wobei der zweite Kondensator (90) während der Entladung mit der Masse, von der getrennt ist, durch einen Transistor (87) verbunden wird, dessen Gate mit dem Gate des Transistors (100) des Analogschalters verbunden ist.

14. Verfahren nach Anspruch 13, wobei der Transistor (87) im gesperrten Zustand ist, wenn das Gate des Transistors (100) des Analogschalters im niedrigen Zustand ist, und im leitenden Zustand ist, wenn das Gate des Transistors (100) des Analogschalters im hohen Zustand ist.

15. Verfahren nach einem der Ansprüche 6 bis 14, wobei die erste Spannung durch das Umschalten wenigstens eines Schalters (48, 60) angelegt wird.

16. Verfahren nach einem der Ansprüche 6 bis 15, wobei die zweite Spannung durch das Umschalten wenigstens eines Schalters (52, 58) angelegt wird.

17. Vorrichtung zur Steuerung eines Analogschalters mit einem Transistor (50, 100), wobei diese Vorrichtung umfasst:
- Einrichtungen um an das Gate des Transistors während einer ersten Phase eine erste Spannung anzulegen, abhängig von der Eingangsspannung Vin des Transistors (50, 100) und einem ersten Potential V1, wobei die erste Spannung fähig ist, den genannten Transistor leitend zu machen,
- Einrichtungen um an das Gate des Transistors während einer zweiten Phase eine zweite Spannung anzulegen, abhängig von der Eingangsspannung Vin des Transistors (50, 100) und einem zweiten Potential V2, wobei die zweite Spannung fähig ist, den genannten Transistor zu sperren, wobei die Differenz zwischen der ersten Spannung und der zweiten Spannung von Vin unabhängig ist.

18. Steuerungsvorrichtung nach Anspruch 17, wobei das erste Potential V1 und das zweite Potential V2 so sind, dass V1=-V2 ist.

19. Steuerungsvorrichtung nach Anspruch 17 oder 18, wobei das erste Potential V1 und das zweite Potential V2 so sind, dass V1=-V2=Vdd ist, mit Vdd als einem Polarisationspotential.

20. Steuerungsvorrichtung nach einem der Ansprüche 17 bis 19, in der der Transistor ein Transistor des P-Typs ist, wobei die erste Spannung und die zweite Spannung jeweils gleich Vin-V1 und Vin-V2 sind, mit V1 positiv und höher als die Schwellenspannung des genannten Transistors, und V2 niedriger als die Schwellenspannung des genannten Transistors.

21. Steuerungsvorrichtung nach einem der Ansprüche 17 bis 19, in der der Transistor ein Transistor des N-Typs ist, wobei die erste Spannung und die zweite Spannung jeweils gleich Vin+V1 und Vin+V2 sind, mit V1 positiv und höher als die Schwellenspannung des genannten Transistors, und V2 niedriger als die Schwellenspannung des genannten Transistors.

22. Steuerungsvorrichtung nach einem der Ansprüche 17 bis 19, wobei die erste Spannung gleich Vin + Vdd ist und die zweite Spannung zu der ersten Spannung symmetrisch ist in Bezug auf die Eingangsspannung Vin und gleich Vin - Vdd ist.

23. Vorrichtung nach Anspruch 22, einen ersten Kondensator (42, 70) umfassend, um die erste Spannung Vin + Vdd anzulegen, während der ersten Phase, zwischen dem Gate und einer Eingangsspannung Vin.

24. Vorrichtung nach Anspruch 23, einen zweiten Kondensator (44, 90) umfassend, um die zweite Spannung Vin - Vdd anzulegen, während der zweiten Phase, zwischen dem Gate und einer Eingangsspannung Vin.

25. Vorrichtung nach Anspruch 24 mit Einrichtungen (Vdd), um den zweiten Kondensator während der ersten Phase wiederaufzuladen und den ersten Kondensator während der zweiten Phase wiederaufzuladen.

26. Vorrichtung nach einem der Ansprüche 23 bis 25, mit einer Spannungsquelle Vdd, um den ersten Kondensator (70) aufzuladen, und Einrichtungen (84), um während der Entladung die Spannungsquelle von dem ersten Kondensator (70) zu trennen.

27. Vorrichtung nach Anspruch 26, wobei die Einrichtungen (84) zur Trennung der Spannungsquelle von dem Kondensator (70) während der Entladung einen Transistor (84) umfassen, dessen Gate mit dem Gate des Transistors (100) des Analogschalters verbunden ist.

28. Vorrichtung nach Anspruch 27, wobei der genannte Transistor (84) im gesperrten Zustand ist, wenn das Gate des Transistors (100) des Analogschalters im hohen Zustand ist, und im leitenden Zustand ist, wenn das Gate des Transistors (100) des Analogschalters im niedrigen Zustand ist.

29. Vorrichtung nach einem der Ansprüche 22 bis 27, die außerdem einen Transistor (96) des Floating-Body-Typs oder mit n (n>2) Wannen umfasst.

30. Vorrichtung nach einem der Ansprüche 24 bis 29, wobei der zweite Kondensator (90) während der Entladung mit der Masse, von der er getrennt ist, durch einen Transistor (87) verbunden wird, dessen Gate mit dem Gate des Transistors (100) des Analogschalters verbunden ist.

31. Vorrichtung nach Anspruch 30, wobei der Transistor (87) im gesperrten Zustand ist, wenn das Gate des Transistors (100) des Analogschalters im niedrigen Zustand ist, und im leitenden Zustand ist, wenn das Gate des Transistors (100) des Analogschalters im hohen Zustand ist.

32. Vorrichtung nach einem der Ansprüche 22 bis 31 mit mindestens einem Schalter (48, 60) zum Anlegen der ersten Spannung.

33. Vorrichtung nach einem der Ansprüche 22 bis 32 mit mindestens einem Schalter (52, 58) zum Anlegen der zweiten Spannung.
